(19) Europäisches Patentamt

European Patent Office

Office européen des brevets

(11) Publication number: 0 492 880 A2

## EUROPEAN PATENT APPLICATION

(21) Application number: 91311456.7

(22) Date of filing: 10.12.91

(51) Int. Cl.⁵: **C23C 16/44**, C23C 16/40

(30) Priority: 24.12.90 US 632813

(43) Date of publication of application:
01.07.92 Bulletin 92/27

(84) Designated Contracting States:
**DE FR GB NL**

(71) Applicant: **GENERAL ELECTRIC COMPANY**
**1 River Road**
**Schenectady, NY 12345(US)**

(72) Inventor: **DeLuca, John Anthony**
**31 Forest Road**
**Burnt Hills, New York 12027(US)**

(74) Representative: **Pratt, Richard Wilson et al**
**London Patent Operation G.E. Technical**
**Services Co. Inc. Essex House 12/13 Essex**
**Street**
**London WC2R 3AA(GB)**

(54) Method of preparing metal oxide films.

(57) A method for depositing dense, continuous, and adherent metal oxide films having a uniform composition is disclosed. An aqueous solution of soluble metal nitrate salts is formed, and nebulized into an aerosol of ultrafine droplets. A substrate having a thermal coefficient of expansion compatible with the metal oxide film is heated to about 280° to 320°C. The aerosol is sprayed on the heated substrate at a preselected velocity that overcomes the thermophoretic repulsion from the heated substrate. The aerosol spray is at a density that flash evaporates on the substrate to form a dense, adherent film of a desired composition without inducing cracking in the substrate. The substrate and metal nitrate film deposited thereon are post-heated to a temperature that partially oxidizes the film so that the film adheres to the substrate, about 450° to 550°C.

FIG. 1

This invention relates to a method of preparing metal oxide films, for example, the precursor metal oxide films that are heat treated to form the yttrium-barium-copper-oxide, thallium-calcium-barium-copper-oxide, or bismuth-strontium-calcium-copper-oxide high temperature oxide superconductors.

Background of the Invention

A great deal of effort has been devoted to the preparation of superconducting films of the high temperature oxide superconductors on various substrates. The films have been deposited on substrates by physical deposition techniques including electron beam evaporation, sputtering, molecular beam epitaxy, ion beam deposition, laser deposition and by chemical deposition techniques, e.g., metal organic deposition. In many of the film deposition techniques, the as deposited films are non-superconducting and post annealing in oxygen is generally required to form the superconducting compounds. The precursor films are usually annealed in oxygen at a temperature of 800° to 950°C and for a period of a few minutes to a few hours.

Superconducting films are typically formed from metal oxide films comprised of the metal components in the stoichiometric composition of the desired superconducting compound. For example, a $Y_1 Ba_2 Cu_3 O_{7-y}$ superconductor is typically formed from a metal oxide precursor film having the same stoichiometry of yttrium, barium, and copper. The $Tl_2 Ca_2 Ba_2 Cu_3 O_{10+y}$ superconductor can be formed from a metal oxide film of calcium, barium, and copper in the stoichiometric ratio 2:2:3, the volatile thallium component can be added during subsequent annealing or as part of the metal oxide film. Similarly, the $Bi_2 Sr_2 Ca_2 Cu_3 O_{10+y}$ superconductor can be formed from a metal oxide film of strontium, calcium, and copper in the stoichiometric ratio 2:2:3, and the volatile bismuth component can be added during subsequent annealing or as part of the metal oxide film.

High quality precursor films can be formed with the physical deposition techniques, but the film formation is very slow and limited in size by the limitations of the high energy beams operated in vacuum chambers in the physical deposition processes. The chemical deposition techniques form lower quality precursor films due to organic contamination, porosity, cracks, and other discontinuities in the precursor films. However, the chemical deposition methods are simpler, provide higher deposition rates, and films of greater size are more easily formed as compared to the physical deposition techniques. Some of the chemical deposition techniques include a spin coating process described, for example, in "Preparation of $Tl_2 Ba_2 Ca_2 Cu_3 O_y$ Thick Films From Ba-Ca-Cu-O Films", Sugise, R. et al., Japanese Journal of Applied Physics, Vol. 27, No. 12, December 1988, pp. L2314-L2316, and a spray pyrolysis technique described, for example, in "Formation of Y-Ba-Cu-O Superconducting Film by a Spray Pyrolysis Method", Kawai, M. et al., Japanese Journal of Applied Physics, Vol. 26, No. 10, October 1987, pp. L1740-1742.

In the spin coating technique referenced above, barium, calcium, and copper-napthenate in a mole ratio of 2:3:3, respectively, were diluted with toluene and spin-coated on yttrium-stabilized zirconia. The samples were heated at 500°C for ten minutes and the spin-coating process was repeated ten times to form the desired film thickness. In the spray pyrolysis method referenced above, an aqueous solution of yttrium, barium, and copper nitrates was prepared from $Y(NO_3)_3 \cdot 3H_2O$, $Ba(NO_3)_3$, and $Cu(NO_3)_2 \cdot 6H_2O$ by dissolving them in distilled water to give the atomic ratio of yttrium, barium, and copper of 1:2:3. The aqueous solution was sprayed over a substrate which was heated to 400°C, followed by heating at 800°C in air. The cycle of spraying and preheating to 800°C was repeated one to four times in order to control the thickness of the film. Film thickness after four repetitions of the procedure was about 5 microns. The films were formed on single crystal cubic zirconia, sintered yttrium-stabilized zirconia, and single crystal strontium titanate.

Superconducting transition temperatures as high as 120 K have been achieved in the oxide superconducting films, however, much research is still directed at methods for improving the current-carrying capacity of the films and improving the current density of the films in a magnetic field. Current-carrying capacity in superconducting films can be improved by providing dense and continuous metal oxide precursor films having a minimum of porosity, and free of cracks or other discontinuities. In addition, the metal oxide precursor films should have a uniform composition with minimized segregation of the constituents to promote the homogeneous formation of the desired superconducting intermetallic compound.

In U.S. Patent 4,654,228 a spray pyrolysis technique is disclosed where ultrafine particles of ceramics are produced by a vapor phase reaction and the ultrafine particles are deposited on a substrate. The substrate is maintained at a temperature lower than that of the vapor phase so as to allow the ultrafine particles produced in the vapor phase to be deposited on the substrate by thermophoresis. When a temperature gradient is established in a gas, the aerosol particles in that gas experience a force in the direction of decreasing temperature. The motion of the aerosol particle that results from this force is called thermophoresis. The temperature gradient produced around the cooled substrate causes the ultrafine particles produced in the vapor phase to diffuse toward the substrate and deposit thereon. Deposition of the ultrafine particles helps to reduce porosity in the ceramic film.

It is an object of this invention to provide a method of spray forming adherent, continuous, and dense metal oxide films.

It is another object of this invention to provide a method of spray forming metal oxide films having minimized segregation of the metal oxides.

It is another object of this invention to provide a method for overcoming the effect of thermophoresis to deposit an aerosol of ultrafine particles on a heated substrate.

It is another object of this invention to provide a method for spray forming metal oxide films with one film deposition step.

Brief Description of the Invention

A dense, continuous and adherent metal oxide film having a uniform composition is formed by the method of this invention. An aqueous solution of soluble metal nitrate salts is formed, and nebulized into an aerosol of ultrafine droplets. As used herein, the term "ultrafine droplets" means droplets up to about 5 microns. A substrate having a thermal coefficient of expansion compatible with the metal oxide film is heated to about 280° to 320°C. The aerosol is sprayed on the heated substrate at a preselected velocity that overcomes the thermophoretic repulsion from the heated substrate, about 1700 to 1900 centimeters per second. The aerosol spray is at a density that flash evaporates on the substrate to form a dense, adherent film of a desired composition without inducing cracking in the substrate. The substrate and metal nitrate film deposited thereon are post-heated to about 450° to 550°C, preferably about 500°C.

The method of this invention for forming metal oxide films advantageously provides for the film to be deposited in one deposition step as opposed to the multiple deposition steps with intermediate high temperature heating up to about 800°C required in known methods.

Brief Description of the Drawings

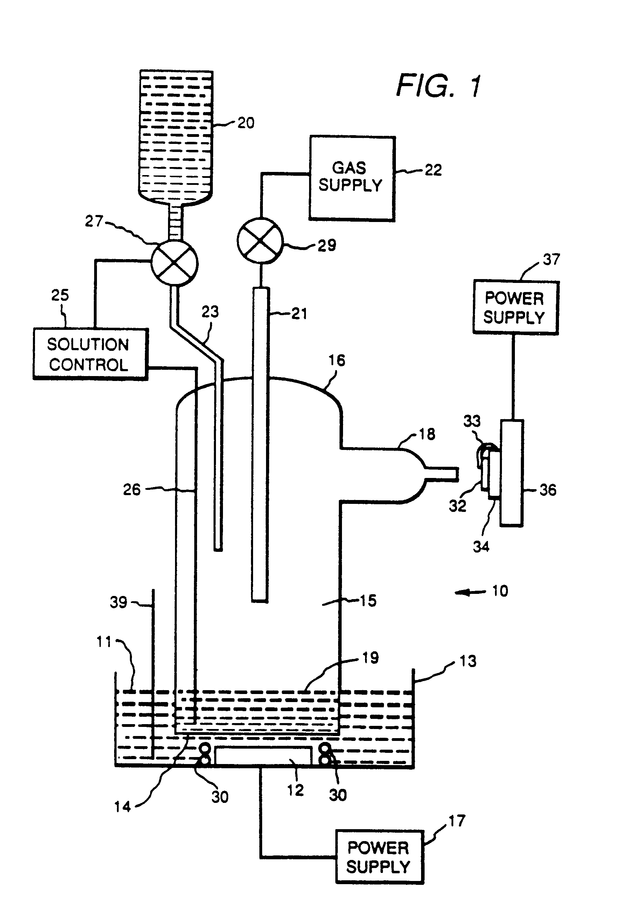

Figure 1 is a schematic showing an aerosol spray apparatus that can be used in the method of this invention.

Detailed Description of the Invention

In the method of this invention metal oxide films having a uniform composition are sprayed in the form of an aerosol having ultrafine droplets that rapidly evaporate after impinging on a heated substrate. The rapid evaporation minimizes segregation of metal salts as they precipitate from the evaporating solution. In other words, the ultrafine droplets minimize segregation of the metals in the film. The ultrafine droplets also minimize thermal shock and consequent cracking of the substrate. However, the fine droplets in an aerosol are repelled from heated substrates by thermophoresis. Surprisingly, we have found that thermophoresis can be overcome to deposit the ultrafine droplets onto heated substrates in a single film deposition step.

The method of this invention is shown by making reference to the apparatus in Figure 1. Spray apparatus 10 is comprised of transducer 12, membrane 14, coolant container 13, vessel 16, nozzle 18, gas tube 21, and solution feeder 20. Vessel 16 is comprised of, for example, a Pyrex glass tube that defines inner chamber 15, and is sealed at its lower end by a flexible membrane or diaphragm 14. The diaphragm 14 may be made of any sound transmissive material that does not react with the aqueous metal nitrate solution, such as flexible plastic, Teflon polytetrafluorethylene, or mylar, preferably, a 0.5 mil FEP Teflon polytetrafluorethylene membrane. The diaphragm 14 and a portion of the end of vessel 16 are immersed in a liquid 11 held in coolant container 13.

A transducer 12 is disposed at the bottom of the coolant container 13 directly beneath the diaphragm 14. A power supply 17 is connected to the transducer 12 driving a piezoelectric oscillator within the transducer. The vessel 16 has at its lower end a quantity of an aqueous solution 19 of metal nitrates. The upper surface of the aqueous solution 19 is at about the same level as the upper surface of liquid 11. Gas tube 21 protrudes into chamber 15 through vessel 16 and is connected to a gas supply 22. Solution tube 23 enters chamber 15 through vessel 16 and is connected to solution feeder 20. Solution controller 25 senses the level of solution 19 using probe 26, and automatically feeds fresh solution from solution feeder 20 to maintain the level of solution 19 by opening and closing valve 27.

Nozzle 18 is sealably attached to an opening in the vessel 16 and necks down to a 4 centimeter length of Pyrex glass tubing having an inside diameter of 5 millimeters. Nozzle 18 is spaced a suitable distance from the surface of solution 19 so that the aerosol formed in chamber 15 is substantially below the nozzle 18. The spray apparatus 10 is designed so that a solution of metal nitrates can be nebulized into an aerosol created within vessel 16, and transported to a substrate 32 where the metal nitrates are deposited by flash evaporation on the surface of the heated substrate.

Substrate 32 is located on a heating mount 34 which in turn is located on an X-Y translation stage 36. Substrate 32 is held by clips 33 onto heating mount 34. Heating mount 34 has Calrod electric resistance heaters, not shown, positioned for even heat distribution across the heating mount. The Calrod electric resistance heaters are electrically connected to a power supply 37 which is connected to a thermocouple, not shown, for controlling the temperature of the Calrod electric resistance heaters. Heating mount 34 is mounted on computer controlled X-Y translation stage 36 having servo motors that provide movement of heating mount 34 in the plane normal to nozzle 18. The computer is programmed to move the X-Y translation stage, having heating mount 34 and substrate 32 mounted thereon, relative to nozzle 18 to deposit a uniform film of the metal nitrates on the substrate surface facing the nozzle.

For example, the X-Y translation stage can be moved at about 3.8 to 6.5 centimeters per second in a pattern similar to the raster pattern used to scan the electron beam in a television tube. A suitable raster pattern is made by spraying the aerosol in a series of parallel lines across the face of the substrate with about 1/8 of an inch between lines. Preferably, overlapping patterns are deposited perpendicular to the previous layer. A spray pattern consisting of first coating the substrate with a horizontal raster pattern followed by depositing a vertical raster pattern perpendicular to the previous layer is herein referred to as a "double sweep spray pattern." A suitable X-Y translation stage and computer control is the Compumotor, Model 3000 Indexer, with Model L-L3C servos, Parker Hannifin Corporation, Ca.

The substrates are made from materials that are compatible with the metal oxide that is to be formed. For example, a suitable substrate at least has a coefficient of thermal expansion that is similar to the coefficient of thermal expansion for the metal oxide film that is to be formed thereon so that the film does not spall from the heated substrate when cooled to room temperature. Suitable substrates materials can also promote preferred orientations in the films either during the formation of the precursor metal oxide film or during subsequent heat treatment of the precursor film. Suitable substrates can also be materials that have minimal chemical reaction with the metal oxide film either during metal oxide formation or during subsequent annealing. Examples of suitable substrates for high temperature oxide superconductor films are alumina, single crystal substrates of yttria stabilized zirconia, cubic zirconia, strontium titanate, sapphire, and lanthanum aluminate.

The heating mount 34 heats substrate 32 to a temperature that provides partial decomposition and bonding of the nitrate film to the substrate, while maintaining the stoichiometry of the spray solution in the film. Substrate 32 is preferably heated to about 280° to 320°C, and most preferably to about 300°C, for receiving the sprayed aerosol stream from solutions comprised of calcium nitrate, barium nitrate, strontium nitrate, yttrium nitrate, copper nitrate, or mixtures thereof. At substrate temperatures above about 320°C the stoichiometry of the nitrate film deposited deviates from that of the solution being sprayed. After the metal nitrate film is deposited on the substrate, the substrate is post-heated to partially oxidize the film so that the film remains adherent on the substrate. Preferably, the substrate is post-heated to about 450 to 550°C for at least about 2 minutes in air, more preferably to about 500°C for about 2 to 5 minutes.

The formation of an aerosol within vessel 16 is accomplished by a process known as ultrasonic nebulization. A liquid such as the solution of metal nitrates 19 is converted to an aerosol by means of the transducer 12 producing ultrasonic waves that are transmitted through coolant liquid 11 to the solution 19 through the diaphragm 14. The transducer 12 is energized by the power supply 17 which excites the piezoelectric transducer 12 at its natural oscillation frequency, about 1.6 to 1.75 megahertz for aqueous solutions. Once the aerosol is formed in chamber 15, valve 29 is opened to supply a preselected flow of pressurized gas from gas supply 22 through gas tube 21 into chamber 15. The gas flow forces the aerosol through nozzle 18 in an aerosol spray at a preselected velocity towards substrate 32. Gas supply 22 provides an inert or oxidizing gas such as air, oxygen, nitrogen or argon. The density and droplet size of the aerosol spray is controlled to provide for rapid deposition of the metal nitrate film, and at the same time minimize thermal shock from the impinging droplets so that cracking of the substrate is prevented.

Ultrasonic nebulization rates increase as the temperature of the nebulized solution increases, and as a result, the temperature of the solution 19 must be controlled to provide a preselected aerosol density. The liquid 11 is used to transfer the ultrasonic energy from the transducer 12 to the solution 19, and cool the transducer 12. Water is a good medium for the transfer and cooling liquid. Additionally, the liquid 11 provides a thermal mass and, hence, permits the liquid 11 to be maintained at a predetermined temperature which does not respond to rapid changes in ambient temperatures. Further, the liquid 11 helps to maintain a stable constant temperature in the solution 19 immersed in liquid 11.

The temperature of the liquid 11 and, therefore, the solution 19 and aerosol may be maintained by cooling coils 30 placed in coolant container 13. Water from a temperature regulated circulating bath, e.g., Lauda Model RM3, Messgerate-Werk-Lauda, West Germany, is pumped through the cooling coils to maintain the preselected temperature in the liquid 11.

During generation of the aerosol within the chamber 15, the transducer 12 is driven at its mechanical resonance, which in a practical example is 1.60 megahertz, by means of the power supply 17. The ultrasonic waves are transmitted through the liquid 11, and membrane 14 to pass through solution 19. The aerosol is formed at the surface of the solution 19.

Solution 19 is an aqueous solution of metal nitrate salts formed by means well known in the art. The metals are dissolved into the solution in the atomic ratio of the desired film. For example, a metal nitrate solution can be prepared by dissolving 5.155 grams of $CaCO_3$, 10.164 grams of $BaCO_3$, and 6.125 grams of CuO in a solution of 25 milliliters of concentrated nitric acid and 100 milliliters of deionized water. The resulting solution is then diluted to a final volume of 1000 milliliters with deionized water to prepare a metal nitrate spray solution that is 0.18 moles per liter in total metal ions. This solution can be sprayed to form a $Ca_2Ba_2Cu_3$ oxide film suitable for annealing with oxygen and thallium to form the $Tl_2Ca_2Ba_2Cu_3O_{10+y}$ superconductor. A metal nitrate solution can also be formed by dissolving 12.162 grams of $Ca(NO_3)_2$-$4H_2O$, 13.460 grams of $Ba(NO_3)_2$, and 17.909 grams of $Cu(NO_3)_2$-$2.5H_2O$ in 500 ml of deionized water. The resulting solution is diluted to a final volume of 1000 ml with deionized water to prepare a spray solution that is 0.18 moles per liter in total metal ions. It has been found that an acceptable metal oxide coating can be formed from a metal nitrate solution having a total metal ion concentration of about 0.1 to 0.3 moles per liter.

A suitable coolant container 13, transducer 12, and power supply 17 are available in an ultrasonic home humidifier, for example, the base unit of a Sunbeam model 678 home humidifier, Northern Electric Co., Illinois. Using the Sunbeam model 678 home humidifier base unit modified to have cooling coils in the coolant container, a suitable aerosol is formed with liquid 11 maintained at a temperature of about 30°C, solution 19 at a level of about 40 millimeters above the transducer surface, and the power setting of the unit at the 40% output setting.

In operation, an aerosol is formed in chamber 15 and gas is introduced into chamber 15 through gas tube 21 from gas supply 22 by opening valve 29. A predetermined gas flow is passed into chamber 15 that produces an aerosol spray velocity through the nozzle of about 1700 to 1900 centimeters per second. The nozzle is positioned a distance of about 3 centimeters from the substrate surface. The high velocity aerosol spray overcomes the thermophoretic effect on the small aerosol droplets from the heated substrate, and prevents complete evaporation of the droplets before they impinge upon the heated substrate surface. Different nozzle sizes and gas flow rates can be used to obtain the desired gas velocity through the nozzle. For example, for the 4 centimeter long by 5 millimeter I.D. nozzle a gas flow of 21 standard liters per minute is acceptable.

Excessive density of the aerosol spray can cause substrate cracking, and porosity and flaking of the film. Because it is difficult to obtain an accurate measure of the aerosol density (droplets/cm$^3$) generated by the ultrasonic transducer, the following is a preferred method for producing the aerosol density that forms dense adherent metal nitrate films without causing substrate cracking. A metal nitrate film is deposited on a preweighed substrate by performing 20 double sweep spray patterns with the X-Y translation stage moving the substrate at about 5 centimeters per second. The metal nitrate film is post-heated and converted to the corresponding metal oxide film. The coating weight is determined by weighing the coated substrate and subtracting the previously determined weight of the substrate. The coating weight per square centimeter is determined by dividing the coating weight by the known coated surface area of the substrate. It has been found that a dense and adherent oxide film having the stoichiometric composition of CaO:BaO:CaO of 2:2:3, has an oxide coating up to about 1.5 milligrams per square centimeter for 20 double sweep spray patterns. As a result, it has been found that dense and adherent metal oxide films can be deposited to a density of up to about $1.61 \times 10^{-5}$ moles of total metal ions per square centimeter for 20 double sweep spray patterns. Aerosol sprays depositing the metal nitrate film, and resulting metal oxide film at higher rates were found to produce increased porosity and flaking of the film, as well as cracking of the substrate. Generally, an adjustment of the ultrasonic nebulizer output to produce an aerosol of a desired density is all that is required to fine tune the process.

An absorbent material can be wrapped around the nozzle outlet to wick away condensed droplets of solution. Excessive cooling of the heating mount can be minimized by providing a stainless steel mask so that only the desired region of the heating mount is exposed to the spray. Absorbent heat resistant material can be placed on the mask to minimize the impingement of large droplets of solution onto the substrate. A pad of glass fiber-based filter paper can be used for the absorbent material.

## Example 1

The aerosol spray apparatus described above having the base unit from a Sunbeam model 678 home humidifier was used to deposit metal nitrate films on single crystal yttria stabilized zirconia substrates heated to different temperatures. One substrate was heated to 300°C and another substrate was heated to 400°C during the film deposition. A 0.18 mole per liter total metal ion solution comprised of yttrium, barium, and copper nitrates having the stoichiometric ratio of 1:2:3 was formed into an aerosol by placing the base unit power setting at 40%. An air flow of 21 standard liters per minute was introduced into the inner chamber of the spray apparatus forcing an aerosol spray at about 1800 centimeters per second from the nozzle of the apparatus positioned about 3 centimeters from the substrate. The substrate was moved in a raster pattern at about 5 centimeters per second, and the aerosol was sprayed over the surface of the substrate with the double sweep spray pattern depositing a metal nitrate film of about 5 microns. Analysis of the deposited films by inductively coupled plasma spectroscopy showed that the film deposited on the substrate heated to 300°C had a stoichiometric composition of Y:Ba:Cu of 1:2:3 while the film on the substrate heated to 400°C had a stoichiometric composition of 0.9:1.7:3.0 respectively.

## Example 2

The film deposition method of Example 1 was repeated with a spray solution of calcium, barium, and copper nitrates having a stoichiometric composition of 2:2:3 respectively. The films were applied on two substrates heated to 300°C during the deposition of the nitrate films. After the nitrate film was deposited one substrate was cooled to room temperature and the second substrate was post-heated to 500°C for about 3 minutes and then cooled to room temperature. Upon cooling, the film on the substrate that was not post-heated cracked and peeled from the substrate, while the film that was post-heated remained adherent on the substrate.

## Claims

1. A method for forming a metal oxide film, comprising:

forming an aqueous solution of soluble metal nitrate salts,

nebulizing the solution into an aerosol of ultrafine droplets,

heating a substrate having a thermal coefficient of expansion compatible with the metal oxide film, to a temperature of about 280° to 320°C,

spraying the aerosol onto the heated substrate at a velocity of about 1700 to 1900 centimeters per second to form a metal nitrate film thereon, the aerosol being at a density that flash evaporates as an adherent film on the heated substrate without inducing cracking in the substrate, and

post-heating the substrate to about 450° to 550°C.

2. the method of claim 1 additionally comprising the step of causing relative motion between the spray and the substrate to form a uniform film over a surface on the substrate facing the spray.

3. The method of claim 1 wherein the substrate is post-heated to about 500°C.

4. The method of claim 1 wherein the aqueous solution has a total metal ion concentration of 0.1 to 0.3 moles per liter.

FIG. 1